# EUROPÄISCHE PATENTSCHRIFT

(11) **EP 3 024 616 B1**
(45) Veröffentlichungstag und Bekanntmachung des Hinweises auf die Patenterteilung: **10.04.2019**
(21) Anmeldenummer: 13742158.2
(22) Anmeldetag: 23.07.2013
(51) Int. Cl.: B23K 26/40, C03B 33/02, C03B 33/09, B23K 26/00, B23K 26/14, B23K 26/04

(54) **VERFAHREN UND VORRICHTUNG ZUR TRENNUNG EINES FLACHEN WERKSTÜCKS IN MEHRERE TEILSTÜCKE**
METHOD AND DEVICE FOR SEPARATING A FLAT WORKPIECE INTO MULTIPLE PARTS
PROCÉDÉ ET DISPOSITIF DE SÉPARATION D'UNE PIÈCE PLATE EN PLUSIEURS SECTIONS

(43) Veröffentlichungstag der Anmeldung: 01.06.2016
(73) Patentinhaber: 3D-Micromac AG, 09126 Chemnitz (DE)
(72) Erfinder: ZÜHLKE, Hans-Ulrich, 07743 Jena (DE); KOITZSCH, Matthias, 91052 Erlangen (DE); LEWKE, Dirk, 91056 Erlangen (DE); TOBISCH, Alexander, 91054 Erlangen (DE)
(74) Vertreter: Gagel, Roland
(86) Internationale Anmeldenummer: PCT/EP2013/002191
(87) Internationale Veröffentlichungsnummer: WO 2015/010706

(56) Entgegenhaltungen:
- JP-A- 2006 007 619
- US-A1- 2013 068 736
- US-B1- 6 744 009

## Beschreibung

### Technisches Anwendungsgebiet

Die vorliegende Erfindung betrifft ein Verfahren zur Trennung eines flachen Werkstücks in mehrere Teilstücke, bei dem in einem ersten Schritt durch lokale Materialbearbeitung mit einem Laserstrahl durch eine Oberfläche des Werkstücks eine oder mehrere Linien modifizierten Materials entlang einer oder mehrerer vorgegebenen Trennlinien im Werkstück erzeugt werden, die zu einer Reduzierung der Bruchspannung des Werkstücks entlang der Trennlinien führen, und in einem zweiten Schritt das Werkstück entlang der Trennlinien durch thermisches Laserstrahl-Separieren in die Teilstücke aufgetrennt wird. Die Erfindung betrifft auch eine Vorrichtung, die zur Durchführung des Verfahrens ausgebildet ist.

In vielen technischen Bereichen ist es erforderlich, ein größeres Werkstück in mehrere in der Regel formgleiche Teilstücke aufzutrennen oder aus einem Werkstück mehrere gleichförmige Strukturen herauszutrennen. Ein Beispiel ist die Vereinzelung von Bauelementen oder Chips in der Halbleiterindustrie oder verwandten Industrien, wie bspw. MEMS, Solar oder Optik. Dort wird eine Vielzahl von Bauelementen auf einem gemeinsamen Substrat gefertigt. Sind die Bauelemente vollständig prozessiert, müssen sie voneinander getrennt werden, damit sie einzeln weiter verarbeitet werden können. Dieser Trennprozess, die Vereinzelung der Bauelemente, lässt sich mit dem vorgeschlagenen Verfahren sowie der vorgeschlagenen Vorrichtung durchführen. An den Vereinzelungsprozess werden unterschiedliche Anforderungen gestellt, bspw. hoher Durchsatz, hohe Qualität und hinreichend genauer geometrischer Verlauf der resultierenden Bauelementkanten, saubere Trennung von Schichtstapeln unterschiedlicher Materialien, keine Qualitätseinbuße der Bauelemente und geringe Kosten pro Vereinzelungsschritt. Das Verfahren und die Vorrichtung lassen sich in gleicher Weise selbstverständlich auch auf anderen technischen Gebieten einsetzen, bspw. in der Glas- und Keramik-Industrie.

### Stand der Technik

Im Folgenden wird die Problematik bei der Trennung eines flachen Werkstücks in mehrere Teilstücke anhand der Anwendung in der Halbleiterindustrie erläutert. Für den Vereinzelungsprozess existieren dort verschiedene Verfahren und Vorrichtungen. Derzeit werden die auf Substraten gefertigten Bauelemente meist mit Hilfe von mechanischen oder laserbasierten Technologien getrennt. Daneben gibt es aus mechanischen und laserbasierten Verfahren kombinierte Technologien sowie Plasmaätzverfahren und Trennverfahren mittels Dünnschleifen. Die beiden letztgenannten Verfahren sowie die kombinierten Verfahren spielen derzeit nur eine untergeordnete Rolle.

Unabhängig von der gewählten Trenntechnologie wird in der Regel vor dem Trennprozess das zu trennende Substrat auf einem Träger fixiert, damit das Substrat während der Bearbeitung nicht verrutscht, die Bauelemente kontrolliert getrennt werden können und bereits getrennte Bauelemente nicht abhanden kommen. Die Art der Fixierung wird abhängig von dem zu bearbeitenden Substrat gewählt. In der Mikroelektronik wird z. B. häufig eine Fixierung des Substrats mit Hilfe einer einseitig klebenden Folie und einem Trägerrahmen gewählt.

Bei den Material abtragenden Laserverfahren wird mit Hilfe eines oder mehrerer gepulster Laserstrahlen so lange Substratmaterial entlang des Ritzrahmens abgetragen, bis alle Bauelemente getrennt sind. Abtragsfreie oder trennfugenfreie Laserverfahren basieren auf der Initialisierung und Führung eines Risses durch das Substrat. Beispiele für derartige abtragsfreie Trennverfahren sind das sog. Stealth Dicing (SD) und das thermische Laserstrahl-Separieren (TLS).

Beim Stealth Dicing, wie es bspw. in der
EP 1 716 960 B1 zum Trennen von Werkstücken verwendet wird, erzeugt ein gepulster Laserstrahl mit hoher Puls-Intensität durch nichtlineare Absorption im Werkstück eine Materialschwächung, an der das Werkstück anschließend durch mechanische Einwirkung gebrochen wird. Zur Trennung von Substraten mit einer Dicke von 200 µm oder dicker, sind jedoch entlang der Trennlinie mehrere Überfahrten mit dem Laserstrahl erforderlich. Dies erhöht die Prozesszeit und verringert damit den Durchsatz. Weiterhin darf das Werkstück die Laserstrahlung bei dieser Technik nicht zu stark absorbieren, um die nichtlinearen Effekte in einer ausreichenden Tiefe im Werkstück erzeugen zu können. Die Trennung von hochdotierten Substraten ist daher nicht möglich, weil die Absorption der Laserstrahlung zu nahe an der Oberfläche stattfindet.

Beim thermischen Laserstrahl-Separieren erfolgt die Trennung des Werkstücks durch Erzeugen einer hohen thermischen Spannung mit einem Laserstrahl, der vom Werkstück ausreichend absorbiert wird. Die Trennung durch diese thermische Spannung erfordert die Initiierung des Bruches durch eine geeignete Materialschwächung am oder im Werkstück. Hierzu ist es bekannt, am Rand des zu trennenden Werkstücks oder entlang einer Trennlinie eine Kerbe in die Oberfläche des Werkstücks einzubringen, durch die der Riss bei der anschließenden starken lokalen Erwärmung mit dem Laserstrahl dann initiiert wird.

Die EP 1 924 392 B1 zeigt hierbei ein Verfahren gemäß dem Oberbegriff des Patentanspruches 1. Bei diesem Verfahren wird vor dem TLS-Schritt durch lokale Materialmodifikation mit einem gepulsten Laser an der Oberfläche des Werkstücks eine Spur modifizierten Materials entlang der Trennlinie erzeugt, die zu einer Reduzierung der Bruchspannung des Werkstücks entlang der Trennlinie führt. Diese Spur ersetzt die bisher eingebrachte Kerbe und kann entlang der Trennlinie auch unterschiedlich tief ausgebildet sein, um eine ggf. variierende Dicke des Werkstücks auszugleichen. Allerdings kann eine Kerbe oder eine anstelle der Kerbe eingebrachte Materialmodifikation an der Oberfläche die Qualität der Kante des abgetrennten Teilstücks bzw. Bauelements verringern.

Aus US 2013/0068736 A1 ist ein Verfahren und eine Vorrichtung zur Trennung eines Werkstücks in mehrere Teilstücke gemäss dem Oberbegriff des Anspruchs 1 bzw. des Anspruchs 11 bekannt. Insbesondere offenbart dieses Dokument ein Verfahren zur Vereinzelung eines Werkstücks in mehrere Teilstücke bekannt, bei dem das Werkstück einer ersten Laserstrahlung ausgesetzt wird, die entlang einer Trennlinie eine Modifikation der Materialeigenschaften bewirkt. Anschließend wird das Werkstück einer zweiten Laserstrahlung ausgesetzt, um die Vereinzelung zu bewirken.

In JP 2006-007619 A wird ein Verfahren zur Trennung von Werkstoffen aus schwer zu bearbeitenden Materialien offenbart, bei dem mittels gepulster Laserstrahlung über Mehr-Photonen-Absorption eine zickzackförmige Modifikation im Inneren des zu trennenden Werkstoffs eingebracht, durch die das Material im Inneren über die gesamte Tiefe derartig geschwächt wird, dass es anschließend leicht mechanisch gebrochen werden kann.

Beim Verfahren gemäß US 6,744,009 B1 wird in einem ersten Schritt mittels einer Kombination von Laserstrahlung und nachfolgender Beaufschlagung mit einem Kühlmedium eine Ritzlinie an der Werkstückoberfläche erzeugt in einem zweiten Schritt mittels Laserbestrahlung thermische Spannungen erzeugt, durch die das Werkstück entlang der vorher erzeugten Ritzlinie gebrochen wird.

Die Aufgabe der vorliegenden Erfindung besteht darin, ein Verfahren sowie eine Vorrichtung zur Trennung eines flachen Werkstücks in mehrere Teilstücke anzugeben, die eine Trennung mit hoher Geschwindigkeit sowie eine gegenüber dem bisherigen thermischen Laserstrahl-Separieren höhere Qualität der resultierenden Kanten der Teilstücke ermöglichen.

### Darstellung der Erfindung

Die Aufgabe wird mit dem Verfahren und der Vorrichtung gemäß den Patentansprüchen 1 und 11 gelöst. Vorteilhafte Ausgestaltungen des Verfahrens sowie der Vorrichtung sind Gegenstand der abhängigen Patentansprüche oder lassen sich der nachfolgenden Beschreibung sowie den Ausführungsbeispielen entnehmen.

Bei dem vorgeschlagenen Verfahren handelt es sich um ein laserbasiertes Trennverfahren, das trennfugenfrei arbeitet. Das Verfahren nutzt die Technik des Thermischen Laserstrahl-Separierens (TLS), bei der durch die Kombination von Laserstrahl und Kühlung entlang der Trennlinie starke thermische Spannungen in das Werkstück eingebracht werden, die zu einem Bruch des Werkstücks entlang der Trennlinie führen. Energie und Intensität der Laserstrahlung werden dabei so gewählt, dass das Werkstückmaterial durch den Laserstrahl nicht modifiziert, insbesondere nicht aufgeschmolzen wird. Vorzugsweise wird hierzu ein CW-Laser (CW: continuous wave) eingesetzt. Die für die Initiierung des Bruches bei TLS erforderliche Materialschwächung wird bei dem vorgeschlagenen Verfahren durch lokale Materialbearbeitung mit einem weiteren Laserstrahl, insbesondere einem gepulsten Laserstrahl, durch die Oberfläche des Werkstücks erreicht. Hierbei werden eine oder mehrere Linien modifizierten Materials entlang der Trennlinien erzeugt. Das vorgeschlagene Verfahren zeichnet sich dadurch aus, dass diese eine oder mehrere Linien nicht ausschließlich entlang der Oberfläche erzeugt werden, sondern sich vollständig oder zumindest abschnittsweise mit einem variierenden Abstand von der Oberfläche im Werkstück erstrecken. Es kann sich dabei um eine durchgehende Linie oder auch um mehrere getrennte Linien handeln, die entlang der Trennlinie auch einen Abstand zueinander aufweisen können. Die Dicke bzw. der Durchmesser der Linien kann über deren Länge auch variieren. Besonders vorteilhaft wird die jeweilige Linie mit einem Verlauf erzeugt, bei dem die Linie an der Oberfläche des Werkstücks startet und sich anschließend von der Oberfläche entfernt und in einem Abstand von der Oberfläche im Werkstück erstreckt, der über die Länge der Linie auch variieren kann. Damit wird die Qualität der Kante des jeweils abzutrennenden Teilstücks bzw. Bauelementes lediglich an der Startposition des Bruches durch die Materialmodifikation an der Oberfläche beeinflusst, so dass der restliche Verlauf der Bauelement- bzw. Teilstückkanten mit hoher Qualität erzeugt werden kann. Unter einer hohen Qualität ist dabei vor allem ein möglichst genauer geometrischer Verlauf der Kante entlang der gewünschten Trennlinie ohne Welligkeiten oder Ausbrüche zu verstehen.

Mit dem vorgeschlagenen Verfahren kann durch Nutzung der Technik des TLS ein hoher Durchsatz bei der Trennung der Teilstücke erreicht werden. Durch die Erzeugung der für die Initiierung und Führung des Bruches verantwortlichen Linien modifizierten Materials zumindest abschnittsweise in einem Abstand zur Oberfläche des Werkstücks wird gleichzeitig eine höhere Qualität der Kante der abgetrennten Teilstücke bzw. Bauelemente erreicht, da die im Abstand zur Oberfläche verlaufenden Linienabschnitte die Teilstück- bzw. Bauelementkante nicht negativ beeinflussen. Die Länge des oder der Linienabschnitte in einem Abstand zur Oberfläche sollte dabei möglichst groß sein, vorzugsweise jedoch größer als die Länge des oder der Linienabschnitte, die an der Oberfläche verlaufen.

Ein weiterer Vorteil des vorgeschlagenen Verfahrens besteht darin, dass der erste Schritt der Erzeugung der Linie(n) auch dazu genutzt werden kann, vorab zunächst eine auf der Oberfläche des Werkstücks befindliche Metallisierung und/oder ausgedehnte PCM-Strukturen (PCM: process control monitoring) im Bereich des Ritzrahmens lokal abzutragen, um eine ausreichende Absorption der Laserstrahlung im Werkstück für das spätere TLS zu ermöglichen oder, um sicherheitsrelevante Strukturen wie z.B. in Security-RFIDs zu entfernen. Das Verfahren erlaubt somit sowohl die Trennung von Werkstücken mit ausgedehnten PCM-Strukturen im Ritzrahmen als auch die Trennung bei Vorhandensein von dünnem Vorderseitenmetall. Weiterhin können mit dem Verfahren bspw. auch Substrate mit größeren Substratdicken, beispielsweise mit mindestens 925 µm Dicke bei Siliziumsubstraten oder mit 450 µm Dicke bei SiC-Substraten, in nur einem Durchgang, d.h. bei nur einer Überfahrt beider Laser über die jeweilige Trennlinie, bei gleichzeitig guter Geradlinigkeit der Trennkante getrennt werden. Das Verfahren ermöglicht auch die Trennung von hochdotierten Halbleiterscheiben bei gleichzeitiger Geradlinigkeit der Trennkante. Auch gestapelte Schichten unterschiedlicher Materialien können mit dem vorgeschlagenen Verfahren getrennt werden. Insbesondere können mit dem Verfahren gestapelte Substrate, z.B. Silizium auf Glas, vollständig bei gleichzeitig guter Geradlinigkeit der Trennkante getrennt werden.

Die bei dem Verfahren im ersten Verfahrensschritt erzeugten Linien modifizierten Materials entlang der Trennlinie können bezüglich des Abstandes von der Oberfläche einer geometrischen Funktion oder auch einem beliebigen Verlauf folgen. Beispielhafte geometrische Funktionen sind z.B. Sinusfunktion, Parabel, eine lineare Funktion, eine Sägezahn- oder eine Dreiecksfunktion. Die jeweilige Abstandsfunktion kann dabei auch in fester Relation zu den Strukturen bzw. Abmessungen der zu trennenden Teilstücke sein, insbesondere abhängig von der Länge des jeweils zu trennenden Teilstücks. Besonders vorteilhaft ist ein Abstandsverlauf, bei dem die jeweilige Linie an Start- und Kreuzungspunkten der Trennlinien an der Oberfläche liegt und sich zwischen diesen Punkten in einem ggf. variierenden Abstand zur Oberfläche im Werkstück erstreckt. In gleicher Weise kann die Linie auch entlang Bereichen mit einer Oberflächenmetallisierung und/oder PCM-Strukturen im Ritzrahmen an der Oberfläche verlaufen.

Bei dem vorgeschlagenen Verfahren können auch zwei oder mehr Linien entlang der definierten Trennlinie in unterschiedlichem Abstand von der Oberfläche übereinander liegen, d. h. sich von der Oberfläche her gesehen bzw. in senkrechter Projektion auf die Oberfläche vollständig oder teilweise entlang der Trennlinie überlappen.

Eine Variation des Abstandes der Linien von der Oberfläche wird vorzugsweise durch Anpassung der Fokuslage des für die Erzeugung der Linien eingesetzten Laserstrahls in Tiefenrichtung des Werkstücks, d.h. des z-Wertes des Fokuspunktes gegenüber der Oberfläche des zu trennenden Werkstücks, erzielt. Diese Variation der Fokuslage kann durch unterschiedliche Techniken realisiert werden. So kann die Fokuslage bspw. mit Hilfe eines Aktors, z.B. eines Piezoelementes oder eines magnetischen Aktors, an einem die relative Fokuslage beeinflussenden Element erfolgen. So kann bspw. durch eine sinusförmige Bewegung der letzten Sammellinse der Fokussieroptik des Laserstrahls vor der Oberfläche des Werkstücks eine entsprechende sinusförmige Abstandsfunktion der Linie im Werkstück erzeugt werden. Selbstverständlich ist die mit dem Aktor erzeugte Variation nicht auf eine derartige Sinusfunktion beschränkt, sondern kann einem beliebig vorgegebenen Verlauf oder auch einer Überlagerung beliebiger geometrischer Funktionen folgen. Es besteht auch die Möglichkeit, den Laser während der Überfahrt des Laserstrahls über das Werkstück gezielt ein- und auszuschalten, um andere Formen der Linie zu erzeugen. Eine weitere Möglichkeit der Variation der Fokuslage in der Tiefenrichtung des Werkstücks besteht in der Nutzung bewegter oder in der Brennweite veränderlicher optischer Elemente, wie bspw. der Spiegelelemente unterschiedlicher Brennweite auf einem Polygonscanner oder durch Nutzung von adaptiven Spiegeln. Auch das Werkstück selbst kann selbstverständlich gegenüber dem Laserbearbeitungskopf in Abstandsrichtung geeignet bewegt werden oder umgekehrt.

Die Erzeugung der Linien kann beim vorgeschlagenen Verfahren mit einem entlang der Linien variierenden Energieeintrag des für die Erzeugung der Linien eingesetzten gepulsten Laserstrahls erfolgen. Dies kann beispielsweise über eine Variation der Pulsenergie/Laserleistung oder auch durch Variation des Pulsabstandes realisiert werden. Die Variation kann in fester Relation zur Struktur des zu trennenden Werkstücks bzw. zu den zu trennenden Teilstücken erfolgen. So kann z.B. an den Start- und Kreuzungspunkten jeweils eine höhere Pulsenergie/Laserleistung eingebracht und/oder ein geringerer Pulsabstand gewählt werden als in den dazwischen liegenden Bereichen.

Für alle Varianten des vorgeschlagenen Verfahrens kann eine Steuerung für die Fokuslage des Laserstrahls beim ersten Verfahrensschritt mit einer Sensorik verwendet werden. Diese ermöglicht bei Bedarf eine Synchronisation der Tiefenposition der Linie, d.h. des Abstands der Linie zur Oberfläche, mit der Struktur des Werkstücks bzw. der abzutrennenden Teilstücke. Die Sensorik dient hierbei der Identifizierung der relativen Position der Oberfläche des zu trennenden Werkstücks gegenüber des Laserfokus und der Identifizierung von eventuell vorhandenen Strukturen an der Oberfläche, wie z.B. Metallisierungsschichten, welche mit Hilfe der gepulsten Laserstrahlung oberflächennah entfernt werden müssen, um ein Eindringen der Laserstrahlung für den zweiten Bearbeitungsschritt zu ermöglichen. Die Steuerung führt dabei den Fokus bei Detektion derartiger Strukturen jeweils an die Oberfläche, um die störenden Strukturen zu entfernen.

Die Vorrichtung zur Durchführung des Verfahrens weist dementsprechend eine erste Lasereinrichtung auf, mit der die eine oder mehreren Linien modifizierten Materials im Werkstück erzeugbar sind, eine zweite Lasereinrichtung, die zum thermischen Laserstrahl-Separieren des Werkstücks entlang der Trennlinien ausgebildet ist, und eine Steuerung, die die erste und die zweite Laserstrahleinrichtung zur Durchführung des Verfahrens ansteuert. Die erste Lasereinrichtung weist dabei Mittel zur Veränderung der Fokuslage des Laserstrahls in der Tiefe des Werkstücks (z-Richtung) auf. Die Steuerung ist so ausgebildet, dass sie die erste Lasereinrichtung bzw. die Mittel zur Veränderung der Fokuslage durch Variation der Fokuslage zur Erzeugung der einen oder der mehreren Linien mit einem variierenden Abstand von der Oberfläche im Werkstück ansteuert.

Die Vorrichtung umfasst auch eine Kühleinrichtung, mit der die Oberfläche des Werkstücks beim thermischen Laserstrahl-Separieren entlang der Trennlinien lokal mit einem Kühlmedium beaufschlagt werden kann. Als Kühlmedium kann beispielsweise Wasser, CO₂ oder N₂ eingesetzt werden, die über eine Sprühdüse auf die Oberfläche des Werkstücks gerichtet werden, um in Kombination mit dem Laserstrahl die für die Trennung erforderlichen mechanischen Spannungen im Werkstück hervorzurufen. Auch andere Kühlmedien können eingesetzt werden.

Die Steuerung kann hierbei verschiedene Betriebsmodi aufweisen, um die erste Lasereinrichtung zur Erzeugung unterschiedlicher Verläufe der Trennlinien gemäß den unterschiedlichen Ausgestaltungen des vorgeschlagenen Verfahrens anzusteuern.

Das Verfahren und die Vorrichtung lassen sich zur Trennung von flachen spröden Werkstücken auf den unterschiedlichsten technischen Gebieten einsetzen, insbesondere für das Trennen von Bauelementen, die auf dünnen Substraten oder Scheiben hergestellt werden. So können im Bereich der Mikroelektronik oder Nanoelektronik Halbleiterscheiben unterschiedlicher Zusammensetzungen hinsichtlich des Substratmaterials und zu trennender Schichtstapel getrennt werden. Hier kommen alle Substrate in Frage, die auch mit den bekannten Verfahren des Standes der Technik bearbeitet werden können. Dies sind z. B. mono- und multikristalline Halbleiter, Verbindungshalbleiter, amorphe Halbleiter für den Einsatz in der Photovoltaik u.a. Auch Systeme mit kombinierten elektrischen, mechanischen, chemischen und/oder biologischen Bestandteilen, z. B. mikroelektromechanische Systeme (MEMS) oder nanoelektromechanische Systeme (NEMS), lassen sich gemäß dem vorgeschlagenen Verfahren bearbeiten. In der Glasindustrie kann das Verfahren bspw. bei der Herstellung von Displays, Fliesen usw. eingesetzt werden. Das Verfahren und die Vorrichtung sind selbstverständlich nicht auf die obigen beispielhaft angeführten Anwendungen beschränkt.

### Kurze Beschreibung der Zeichnungen

Das vorgeschlagene Verfahren und die zugehörige Vorrichtung werden nachfolgend anhand von Ausführungsbeispielen in Verbindung mit den Zeichnungen nochmals näher erläutert. Hierbei zeigen:
- Fig. 1: eine schematische Darstellung eines Abschnittes eines Substrates mit Bauelementen in Draufsicht;
- Fig. 2: eine schematische Querschnittsdarstellung eines Abschnitts eines Substrates, in dem eine sinusförmige Linie gemäß dem vorgeschlagenen Verfahren erzeugt wird;
- Fig. 3: eine schematische Querschnittsdarstellung durch zwei exemplarische Bauelemente bzw. Teilstücke mit einer gemäß dem Verfahren erzeugten Linie modifizierten Materials;
- Fig. 4: eine schematische Querschnittsdarstellung eines Abschnitts eines Substrates, in dem mehrere (im Beispiel zwei) Liniensegmente modifizierten Materials gemäß dem vorgeschlagenen Verfahren erzeugt wurden; und
- Fig. 5: eine weitere schematische Querschnittsdarstellung eines Abschnitts eines Substrates, in dem mehrere (im Beispiel zwei) Liniensegmente modifizierten Materials gemäß dem vorgeschlagenen Verfahren erzeugt wurden.

### Wege zur Ausführung der Erfindung

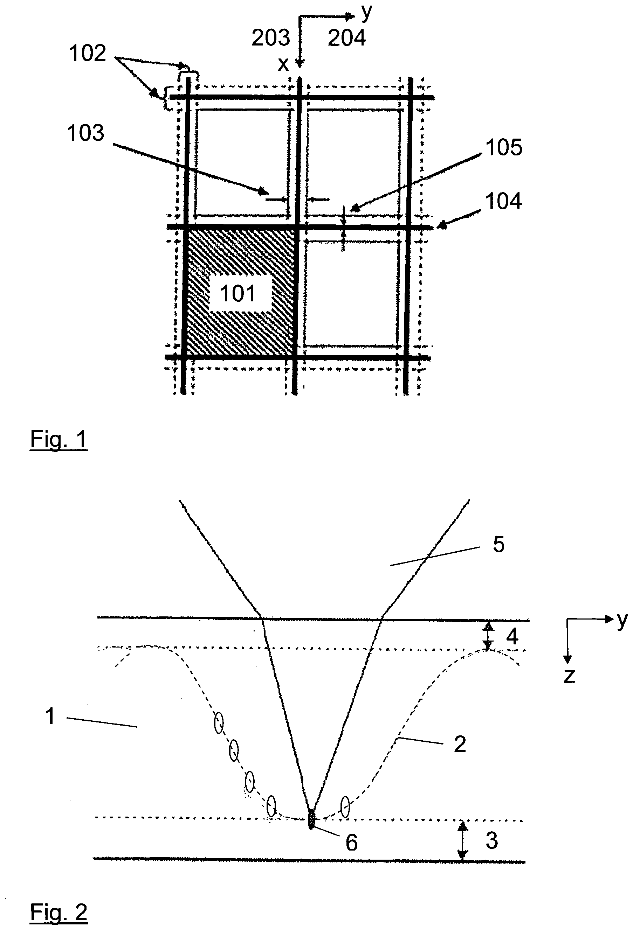

Figur 1 zeigt in Draufsicht einen Ausschnitt aus einem Substrat 1 mit zu trennenden Chips 101 als Bauelemente, um die hier auftretenden Begriffe zu klären. In der Figur sind außer den Chips 101 auch der Ritzrahmen 102, die Ritzrahmenbreite 103, die Trennfuge (Kerf) 104, die Trennfugen-Breite 105 sowie die Bewegungsrichtungen 203, 204 (X- und Y-Richtung)beim Durchführen der Trennschritte angedeutet.

Figur 2 zeigt einen Querschnitt durch ein entsprechendes Substrat 1, das in einzelne Teilstücke bzw. Bauelemente vereinzelt werden soll. Das vorgeschlagene Verfahren setzt hierbei zwei getrennte Bearbeitungsschritte ein. Im ersten Schritt werden eine oder mehrere Linien 2 modifizierten Materials entlang der definierten Trennlinie zur Lokalisierung des TLS-Rissstarts und zur Führung des TLS-Risses durch geeignete Fokussierung eines gepulsten Laserstrahls 5 auf und/oder in das zu trennende Substrat 1 erzeugt. Im Beispiel der Figur 2 hat die mit dem Laserstrahl 5 erzeugte Linie 2 modifizierten Materials einen sinusförmig variierenden Abstand von der Oberfläche des Substrates 1 sowie auch einen entsprechenden Abstand von der Rückseite. In diesem Beispiel werden ein Mindestabstand 4 zur Oberfläche sowie ein Mindestabstand 3 zur Rückseite des Substrates 1 eingehalten. Die Variation des Abstandes wird durch Veränderung der Tiefenlage des Fokus 6 des Laserstrahls 5 im Substrat 1 erzeugt. Die Mindestabstände 3, 4 können bei dem vorgeschlagenen Verfahren auch Null werden, so dass die Linie 2 auch abschnittsweise an der Oberfläche und/oder Rückseite des Substrates 1 verlaufen kann. Bei dem vorgeschlagenen Verfahren wird ein Verlauf an der Oberfläche vorzugsweise nur an bestimmten Stellen, bspw. zur Initiierung des Risses oder an Kreuzungspunkten von Trennlinien erzeugt, um die Qualität der Bauteilkanten der getrennten Bauteile nicht durch diese Materialmodifikation zu beeinträchtigen.

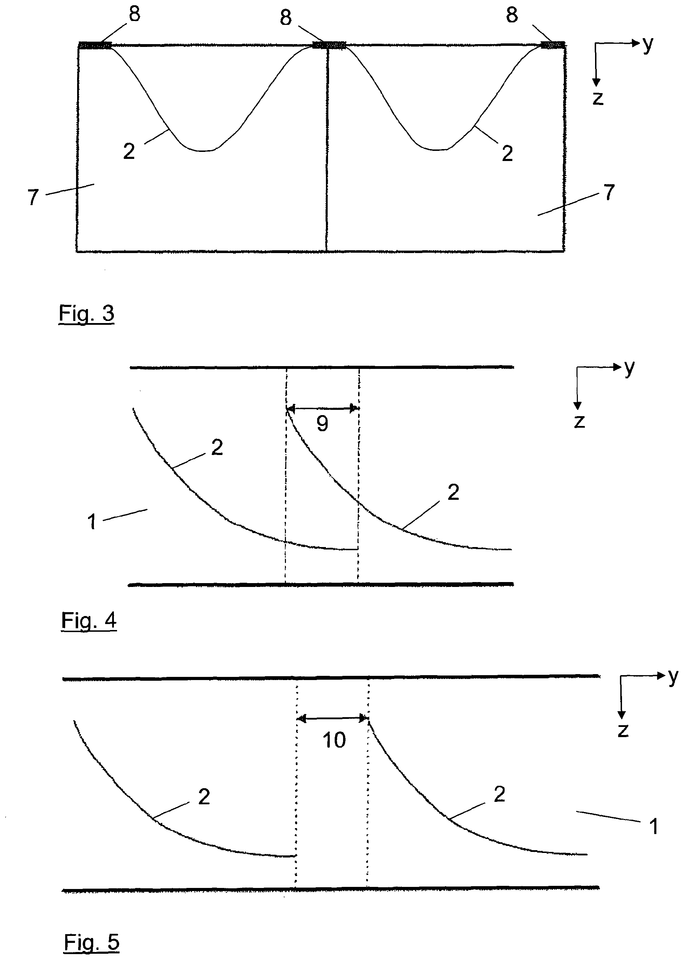

Figur 3 zeigt ein Beispiel, bei der die Abstandsfunktion der erzeugten Linie 2 von der Oberfläche periodisch verläuft und an die Dimensionen der zu trennenden Bauelemente 7 angepasst ist. Figur 3 zeigt hierbei einen Querschnitt durch zwei exemplarische Bauelemente 7 eines Substrates. Der Verlauf der Linie 2 ist hierbei so gewählt, dass die Linie 2 an den jeweiligen Rändern der Bauelemente 7 an der Oberfläche liegt, während sie sich dazwischen in die Tiefe erstreckt. Diese Start- bzw. Endpunkte 8 der jeweiligen Linie zur Lokalisierung und Führung des TLS-Risses bei der Vereinzelung der Bauelemente 7 werden somit hier an der Oberfläche gewählt.

Figur 4 zeigt schließlich ein weiteres Beispiel für einen möglichen Verlauf der Linien 2 im Substrat 1. Bei dieser Ausgestaltung sind in dem im Querschnitt dargestellten Abschnitt des Substrats 1 zwei entlang der Trennlinie aufeinander folgende Linien 2 erzeugt, die sich in einem Bereich 9 um einen bestimmten Wert überlappen. Die Überlappung wird durch den unterschiedlichen Abstand der beiden, in diesem Beispiel gebogenen, Linien 2 von der Oberfläche im überlappenden Bereich 9 realisiert.

Figur 5 zeigt schließlich ein weiteres Beispiel einer Variante von, in diesem Beispiel gebogenen, Linien 2, die sich in diesem Fall nicht überlappen, sondern in Richtung der jeweiligen Trennlinie einen entsprechenden Abstand 10 zueinander aufweisen.

Der geometrische Verlauf der Linien 2, eine eventuelle Überlappung oder ein eventueller Abstand werden je nach Anforderungen und gewünschtem Ergebnis der Trennung der Bauteile in Abhängigkeit von dem Werkstückmaterial und der Werkstückdicke gewählt. Nach dem Einbringen der entsprechenden Linie(n) im ersten Schritt wird im zweiten Schritt der TLS-Prozess durchgeführt, um das Substrat vollständig zu trennen (Cleave-Schritt). Dies erfolgt durch thermisch induzierte mechanische Spannungen, welche durch eine Kombination aus einem weiteren Laser und einer Kühlung entlang der Trennlinie eingebracht werden.

So kann bspw. zur Trennung eines Siliziumsubstrates einer Dicke von 400 µm in einzelne Chips für die Erzeugung der Linien im ersten Schritt ein gepulster Nd:YAG-Laser mit einer mittleren Leistung von 1,2 W eingesetzt werden. Für den anschließenden TLS-Schritt kann dann ein Yb:YAG CW-Laser mit einer cw-Laserleistung von 130 W und einer Vorschubgeschwindigkeit von 250 mm/s eingesetzt werden.

Das vorgeschlagene Verfahren hat gegenüber den bekannten Verfahren des Stealth-Dicing (SD) und des bisher bekannten thermischen Laserstrahl-Separierens (TLS) mit einer Ritzkante bzw. Linie entlang der Oberfläche des Werkstücks zahlreiche Vorteile, wie sie aus der nachfolgenden Tabelle zu entnehmen sind:

| # | Merkmal | Vorgeschlagenes Verfahren | SD | TLS |
|---|---|---|---|---|
| 1 | Ablationsfreie Trennung von dünnem Rückseitenmetall | Ja | Nein | Ja |
| 2 | Trennung von ausgedehnten PCM-Strukturen im Ritzrahmen | Ja | Nein | Eingeschränkt |
| 3 | Trennung von dünnem Vorderseitenmetall | Ja | Nein | Nein |
| 4 | Kombinierter "Ein-Pass-Prozess" für Substratdicken bis 925 µm (Si) bzw. 450 µm (SiC) | Ja | Nein | Ja |
| 5 | Trennung hochdotierter Scheiben | Ja | Nein | Ja |
| 6 | Geradlinigkeit der Trennkante | Gut | Gut | Weniger gut |
| 7 | Qualität der Seitenfläche | Modifikation wenige µm, unabhängig von Substratdicke, Rest glatt | Modifikation ca. 50% der Substratdicke, Rest glatt | Glatt |
| 8 | Abhängigkeit der Ritzrahmenbreite von der Scheibendicke | Gering | Stark | Gering |
| 9 | Selektive Trennung gestapelter Substrate | Gut und gerade | Nein | Gut, weniger gerade |
| 10 | Vollständige Trennung gestapelter Substrate | Gut und gerade | Nein | Gut, weniger gerade |
| 11 | Trennung vibrations- und/oder schockempfindlicher Bauelemente, z.B. MEMS | Ja | Eingeschränkt | Eingeschränkt |

### Bezugszeichenliste

- 1: Substrat
- 2: Linie
- 3: Mindestabstand zur Rückseite
- 4: Mindestabstand zur Oberfläche
- 5: Laserstrahl
- 6: Laserfokus
- 7: Bauelemente
- 8: Start- bzw. Endpunkt einer Linie
- 9: Überlappender Bereich
- 10: Abstand zwischen zwei Linien
- 101: Chip
- 102: Ritzrahmen
- 103: Ritzrahmenbreite
- 104: Trennfuge
- 105: Trennfugen-Breite
- 203: X-Richtung
- 204: Y-Richtung

## Patentansprüche

1. Verfahren zur Trennung eines Werkstücks (1) in mehrere Teilstücke (7), bei dem
- in einem ersten Schritt durch lokale Materialbearbeitung mit einem Laserstrahl (5) durch eine Oberfläche des Werkstücks eine oder mehrere Linien (2) modifizierten Materials entlang einer oder mehrerer vorgegebener Trennlinien im Werkstück (1) erzeugt werden, die zu einer Reduzierung der Bruchspannung des Werkstücks (1) entlang der Trennlinien führen, und
- in einem zweiten Schritt das Werkstück (1) entlang der Trennlinien durch thermisches Laserstrahl-Separieren in die Teilstücke (7) aufgetrennt wird, **dadurch gekennzeichnet,**
**dass** die eine oder die mehreren Linien (2) vollständig oder zumindest abschnittsweise mit einem variierenden Abstand von der Oberfläche im Werkstück (1) erzeugt werden, und
**dass** durch eine Kombination von Laserstrahlung und lokaler Beaufschlagung mit einem Kühlmedium entlang der Trennlinien thermische Spannungen im Werkstück erzeugt werden.

2. Verfahren nach Anspruch 1,
**dadurch gekennzeichnet,**
**dass** die eine oder die mehreren Linien (2) jeweils so erzeugt werden, dass sie an der Oberfläche des Werkstücks (1) starten und sich dann mit dem variierenden Abstand zur Oberfläche entlang der Trennlinie im Werkstück (1) erstrecken.

3. Verfahren nach Anspruch 1 oder 2,
**dadurch gekennzeichnet,**
**dass** die eine oder die mehreren Linien (2) jeweils so erzeugt werden, dass sie an einer Randposition jedes Teilstückes (7) an der Oberfläche starten und sich dann mit dem variierenden Abstand zur Oberfläche entlang der Trennlinie im Werkstück (1) erstrecken.

4. Verfahren nach Anspruch 1,
**dadurch gekennzeichnet,**
**dass** die eine oder die mehreren Linien (2) jeweils so erzeugt werden, dass sie an einer ersten Randposition jedes Teilstückes (7) an der Oberfläche starten, sich dann mit dem variierenden Abstand zur Oberfläche entlang der Trennlinie im Werkstück (1) erstrecken und an einem der ersten Randposition am Teilstück (7) gegenüberliegenden zweiten Randposition wieder an die Oberfläche treten.

5. Verfahren nach einem der Ansprüche 1 bis 4,
**dadurch gekennzeichnet,**
**dass** die eine oder die mehreren Linien (2) als Linien aufgeschmolzenen und/oder amorphisierten und/oder an der Oberfläche abgetragenen Materials erzeugt werden.

6. Verfahren nach einem der Ansprüche 1 bis 5,
**dadurch gekennzeichnet,**
**dass** mindestens zwei der Linien (2) erzeugt werden, die entlang der Trennlinien teilweise übereinander liegen.

7. Verfahren nach einem der Ansprüche 1 bis 6,
**dadurch gekennzeichnet,**
**dass** die eine oder die mehreren Linien (2) mit entlang der Linien (2) variierendem Energieeintrag des Laserstrahls (5) erzeugt werden.

8. Verfahren nach einem der Ansprüche 1 bis 7,
**dadurch gekennzeichnet,**
**dass** die eine oder die mehreren Linien (2) mit einem gepulsten Laserstrahl (5) erzeugt werden.

9. Verfahren nach einem der Ansprüche 1 bis 8,
**dadurch gekennzeichnet,**
**dass** der variierende Abstand der einen oder der mehreren Linien (2) von der Oberfläche des Werkstücks durch Variation einer Fokuslage des Laserstrahls (5) in Dickenrichtung des Werkstücks (1) erzeugt wird.

10. Verfahren nach einem der Ansprüche 1 bis 9,
**dadurch gekennzeichnet,**
**dass** die eine oder die mehreren Linien (2) jeweils im Bereich von Oberflächenstrukturen oder einer Oberflächenmetallisierung auf den Trennlinien, die eine Einkopplung von Laserstrahlung für das thermische Laserstrahl-Separieren in das Werkstück (1) behindern würden, an die Oberfläche geführt werden, um diese Oberflächenstrukturen oder Oberflächenmetallisierung auf den Trennlinien mit dem Laserstrahl (5) lokal zu entfernen.

11. Vorrichtung zur Trennung eines Werkstücks (1) in mehrere Teilstücke, die zumindest aufweist:
- eine erste Lasereinrichtung, mit der durch lokale Materialbearbeitung mit einem Laserstrahl (5) durch eine Oberfläche eines Werkstücks eine oder mehrere Linien (2) modifizierten Materials entlang einer oder mehrerer vorgegebener Trennlinien im Werkstück (1) erzeugbar sind, die zu einer Reduzierung der Bruchspannung des Werkstücks (1) entlang der Trennlinien führen,
- eine zweite Lasereinrichtung, die zum thermischen Laserstrahl-Separieren des Werkstücks entlang der Trennlinien ausgebildet ist, und
- eine Steuerung für die erste und die zweite Laserstrahleinrichtung zur Erzeugung der einen oder der mehreren Linien (2) im Werkstück (1) und zur anschließenden Durchführung des thermischen Laserstrahl-Separierens,
wobei die erste Lasereinrichtung Mittel zur Veränderung einer Fokuslage des Laserstrahls (5) in der Tiefe des Werkstücks (1) aufweist, **dadurch gekennzeichnet, dass** die Steuerung die erste Lasereinrichtung durch Variation der Fokuslage zur Erzeugung der einen oder der mehreren Linien (2) mit einem variierenden Abstand von der Oberfläche im Werkstück (1) ansteuert, und
- dass eine von der Steuerung ansteuerbare Kühleinrichtung vorgesehen ist, mit der die Oberfläche des Werkstücks beim thermischen Laserstrahl-Separieren entlang der Trennlinien lokal mit einem Kühlmedium beaufschlagt werden kann.

12. Vorrichtung nach Anspruch 11,
**dadurch gekennzeichnet,**
**dass** die erste Lasereinrichtung einen gepulsten Laser und die zweite Lasereinrichtung einen cw-Laser umfasst.

13. Vorrichtung nach Anspruch 11 oder 12,
**dadurch gekennzeichnet,**
**dass** die Steuerung einen Betriebsmodus aufweist, in dem sie die erste Lasereinrichtung so zur Erzeugung der einen oder der mehreren Linien (2) ansteuert, dass die Linien (2) an einer der Steuerung vorgegebenen Randposition jedes Teilstückes (7) an der Oberfläche starten und sich dann mit einem variierenden Abstand zur Oberfläche entlang der Trennlinie im Werkstück (1) erstrecken.

14. Vorrichtung nach einem der Ansprüche 11 bis 13,
**dadurch gekennzeichnet,**
**dass** die Steuerung einen Betriebsmodus aufweist, in dem sie die erste Lasereinrichtung so zur Erzeugung der einen oder der mehreren Linien (2) ansteuert, dass die Linien (2) an einer der Steuerung vorgegebenen ersten Randposition jedes Teilstückes (7) an der Oberfläche starten, sich dann mit einem variierenden Abstand zur Oberfläche entlang der Trennlinie im Werkstück (1) erstrecken und an einem der ersten Randposition am Teilstück (7) gegenüberliegenden, der Steuerung vorgegebenen zweiten Randposition wieder an die Oberfläche treten.

15. Vorrichtung nach einem der Ansprüche 11 bis 14,
**dadurch gekennzeichnet,**
**dass** die Steuerung so ausgebildet ist, dass sie die erste Lasereinrichtung zur Erzeugung der einen oder der mehreren Linien (2) mit entlang der Linien (2) variierendem Energieeintrag des Laserstrahls (5) ansteuern kann.

16. Vorrichtung nach einem der Ansprüche 11 bis 15,
**dadurch gekennzeichnet,**
**dass** die Steuerung mit einer Sensoranordnung verbunden ist, die auf der Oberfläche des Werkstücks im Bereich der Trennlinien vorhandene Strukturen erkennt, und so ausgebildet ist, dass sie bei Detektion derartiger Strukturen auf den Trennlinien die Fokuslage des Laserstrahls (5) bei der Erzeugung der einen oder der mehreren Linien (2) so steuert, dass diese Strukturen mit dem Laserstrahl (5) entfernt werden.

## Claims

1. Method for separating a workpiece (1) into multiple sections (7), in which
- in a first step one or more lines (2) of modified material is/are created along one or more predefined separating lines in the workpiece (1) through a surface of the workpiece by way of local material processing with a laser beam (5), which lead to a reduction of breaking tension of the workpiece (1) along the separating lines; and
- in a second step the workpiece (1) is separated into the sections (7) along the separating lines by thermal laser separation,
**characterized in that**
the one or more lines (2) is/are created in the workpiece entirely or at least partially at a varying distance from the surface, and
thermal stresses are generated along the separating lines in the workpiece by a combination of laser irradiation and local application of a cooling medium.

2. Method according to Claim 1,
**characterized in that**
the one or more lines (2) is/are each created in such manner that they start at the surface of the workpiece (1) and then extend along the separating line in the workpiece (1) at the varying distance from the surface.

3. Method according to Claim 1 or 2,
**characterized in that**
the one or more lines (2) is/are each created in such manner that they start on the surface at an edge position of each section (7) and then extend along the separating line in the workpiece (1) at the varying distance from the surface.

4. Method according to Claim 1,
**characterized in that**
the one or more lines (2) is/are each created in such manner that they start on the surface at a first edge position of each section (7), then extend along the separating line in the workpiece (1) at the varying distance from the surface and reach the surface again at a second edge position opposite the first edge position on the section (7).

5. Method according to any one of Claims 1 to 4,
**characterized in that**
the one or more lines (2) is/are created as lines of material that has been melted and/or amorphised and/or removed at the surface.

6. Method according to any one of Claims 1 to 5,
**characterized in that**
at least two of the lines (2) are created which partly lie one above the other along the separating lines.

7. Method according to any one of Claims 1 to 6,
**characterized in that**
the one or more lines (2) is/are created with energy input from the laser beam (5) which varies along the lines (2).

8. Method according to any one of Claims 1 to 7,
**characterized in that**
the one or more lines (2) is/are created with a pulsed laser beam.

9. Method according to any one of Claims 1 to 8,
**characterized in that**
the varying distance of the one or more lines (2) from the surface of the workpiece is produced by variation of a focal position of the laser beam (5) in the direction of the thickness of the workpiece (1).

10. Method according to any one of Claims 1 to 9,
**characterized in that**
the one or more lines (2) are each guided to the surface in the region of surface structures or a surface metallisation on the separating lines what would prevent the laser irradiation for thermal laser separation from being coupled into the workpiece (1) in order to remove said surface structures or surface metallisation on the separating lines with the laser beam (5).

11. Device for separating a workpiece (1) into multiple sections, consisting of at least:
- a first laser device with which one or more lines (2) of modified material can be created along one or more predefined separating lines in the workpiece (1) through a surface of the workpiece by way of local material processing with a laser beam (5), which lines (2) of modified material lead to a reduction in the breaking tension of the workpiece (1) along the separating lines,
- a second laser device which is designed for thermal laser separation of the workpiece along the separating lines, and
- a controller for the first and second laser beam devices for creating the one or more lines (2) in the workpiece (1) and subsequently carrying out the thermal laser separation,
wherein the first laser device has means for changing the focal position of the laser beam (5) in the depth of the workpiece (1),
**characterized in that**
the controller controls the first laser device by varying the focal position to create the one or more lines (2) in the workpiece (1) with a varying distance from the surface, and
- a cooling device that is controllable by the controller is provided, with which a cooling medium can be applied to the surface of the workpiece locally along the separating lines during thermal laser separation.

12. Device according to Claim 11,
**characterized in that**
the first laser device comprises a pulsed laser and the second laser device comprises a cw laser.

13. Device according to Claim 11 or 12,
**characterized in that**
the controller has an operating mode in which it controls the first laser device in order to create the one or more lines (2) in such manner that the lines (2) start on the surface at an edge position of each section (7) that is predetermined for the controller and then extend along the separating line in the workpiece (1) at the varying distance from the surface.

14. Device according to any one of Claims 11 to 13,
**characterized in that**
the controller has an operating mode in which it controls the first laser device in order to create the one or more lines (2) in such manner that the lines (2) start on the surface at a first edge position of each section (7) that is predetermined for the controller, then extend along the separating line in the workpiece (1) at the varying distance from the surface and reach the surface again at a second edge position opposite the first edge position on the section (7).

15. Device according to any one of Claims 11 to 14,
**characterized in that**
the controller is designed in such manner that it is able to control the first laser device to create the one or more lines (2) with varying energy input from the laser beam (5) along the lines (2).

16. Device according to any one of Claims 11 to 15,
**characterized in that**
the controller is connected to a sensor arrangement which detects structures present in the region of the separating lines on the surface of the workpiece and is designed in such manner that upon detection of such structures on the separating lines it controls the focal position of the laser beam (5) when creating the one or more lines (2) in such manner that said structures are removed with the laser beam (5).

## Revendications

1. Procédé pour la séparation d'une pièce à usiner (1) en plusieurs éléments (7), dans lequel
- dans une première étape, par usinage local de matériau avec un faisceau laser (5) à travers une surface de la pièce à usiner, une ou plusieurs lignes (2) de matériau modifié le long d'une ou plusieurs lignes de séparation prédéfinies dans la pièce à usiner (1) sont générées, lesquelles produisent une réduction de la contrainte de rupture de la pièce à usiner (1) le long des lignes de séparation, et
- dans une deuxième étape, la pièce à usiner (1) est séparée en les éléments (7) le long des lignes de séparation par séparation thermique au faisceau laser,
**caractérisé en ce**
**que** cette ou ces lignes (2) sont générées complètement ou au moins en partie dans la pièce à usiner (1) avec une distance variable par rapport à la surface, et
**que** grâce à une combinaison entre rayonnement laser et application locale avec un agent de refroidissement, des contraintes thermiques sont générées le long des lignes de séparation dans la pièce à usiner.

2. Procédé selon la revendication 1,
**caractérisé en ce**
**que** cette ou ces lignes (2) sont respectivement générées de manière à ce qu'elles débutent à la surface de la pièce à usiner (1) et s'étendent ensuite à la distance variable par rapport à la surface le long de la ligne de séparation dans la pièce à usiner (1).

3. Procédé selon la revendication 1 ou 2,
**caractérisé en ce**
**que** cette ou ces lignes (2) sont respectivement générées de manière à ce qu'elles débutent à la surface au niveau d'une position de bord de chaque élément (7) et s'étendent ensuite à la distance variable par rapport à la surface le long de la ligne de séparation dans la pièce à usiner (1).

4. Procédé selon la revendication 1,
**caractérisé en ce**
**que** cette ou ces lignes (2) sont respectivement générées de manière à ce qu'elles débutent à la surface au niveau d'une première position de bord de chaque élément (7), s'étendent ensuite à la distance variable par rapport à la surface le long de la ligne de séparation dans la pièce à usiner (1), et reviennent de nouveau à la surface au niveau d'une deuxième position de bord située en vis-à-vis de la première position de bord sur l'élément (7).

5. Procédé selon l'une des revendications 1 à 4,
**caractérisé en ce**
**que** cette ou ces lignes (2) sont générées en tant que lignes de matériau fondu et/ou amorphisé et/ou enlevé à la surface.

6. Procédé selon l'une des revendications 1 à 5,
**caractérisé en ce**
**qu'**au moins deux des lignes (2) sont générées, lesquelles se situent partiellement l'une sur l'autre le long de la ligne de séparation.

7. Procédé selon l'une des revendications 1 à 6,
**caractérisé en ce**
**que** cette ou ces lignes (2) sont générées avec une introduction d'énergie variable du faisceau laser (5) le long des lignes (2).

8. Procédé selon l'une des revendications 1 à 7,
**caractérisé en ce**
**que** cette ou ces lignes (2) sont générées avec un faisceau laser (5) pulsé.

9. Procédé selon l'une des revendications 1 à 8,
**caractérisé en ce**
**que** la distance variable de cette ou ces lignes (2) par rapport à la surface de la pièce à usiner est générée par variation d'une position de focalisation du faisceau laser (5) dans le sens de l'épaisseur de la pièce à usiner (1).

10. Procédé selon l'une des revendications 1 à 9,
**caractérisé en ce**
**que** cette ou ces lignes (2) sont menées vers la surface respectivement dans la zone de structures de surface ou d'une métallisation de surface sur les lignes de séparations, lesquelles empêcheraient une injection de rayonnement laser dans la pièce à usiner (1) pour la séparation thermique par faisceau laser, pour éliminer localement ces structures de surface ou cette métallisation de surface sur les lignes de séparation avec le faisceau laser (5).

11. Dispositif pour la séparation d'une pièce à usiner (1) en plusieurs éléments, lequel présente au moins :
- un premier dispositif laser avec lequel, par usinage local de matériau avec un faisceau laser (5) à travers une surface d'une pièce à usiner, une ou plusieurs lignes (2) de matériau modifié le long d'une ou plusieurs lignes de séparation prédéfinies dans la pièce à usiner (1) peuvent être générées, lesquelles produisent une réduction de la contrainte de rupture de la pièce à usiner (1) le long des lignes de séparation, et
- un deuxième dispositif laser, lequel est réalisé pour la séparation thermique par faisceau laser de la pièce à usiner le long des lignes de séparation, et
- un dispositif de commande pour le premier et le deuxième dispositif laser pour la génération de cette ou ces lignes (2) dans la pièce à usiner (1) et pour la réalisation qui s'en suit de la séparation thermique par faisceau laser,
dans lequel le premier dispositif laser présente des moyens pour modifier une position de focalisation du faisceau laser (5) dans la profondeur de la pièce à usiner (1),
**caractérisé en ce**
**que** le dispositif de commande assure la commande du premier dispositif laser par variation de la position de focalisation pour la génération de cette ou ces lignes (2) avec une distance variable par rapport à la surface dans la pièce à usiner (1), et
- **qu'**un dispositif de refroidissement pouvant être commandé par le dispositif de commande est prévu avec lequel, lors de la séparation thermique par faisceau laser, on peut appliquer localement un agent de refroidissement sur la surface de la pièce à usiner le long des lignes de séparation.

12. Dispositif selon la revendication 11,
**caractérisé en ce**
**que** le premier dispositif laser comprend un laser pulsé et le deuxième dispositif laser, un laser continu.

13. Dispositif selon la revendication 11 ou 12,
**caractérisé en ce que**
le dispositif de commande présente un mode de fonctionnement dans lequel il commande le premier dispositif laser pour la génération de cette ou ces lignes (2) de telle sorte que les lignes (2) débutent à la surface au niveau d'une position de bord, prédéfinie pour le dispositif de commande, de chaque élément (7) et s'étendent ensuite à une distance variable par rapport à la surface le long de la ligne de séparation dans la pièce à usiner (1).

14. Dispositif selon l'une des revendications 11 à 13,
**caractérisé en ce que**
le dispositif de commande présente un mode de fonctionnement dans lequel il commande le premier dispositif laser pour la génération de cette ou ces lignes (2) de telle sorte que les lignes (2) débutent à la surface au niveau d'une position de bord, prédéfinie pour le dispositif de commande, de chaque élément (7), s'étendent ensuite à une distance variable par rapport à la surface le long de la ligne de séparation dans la pièce à usiner (1) et reviennent de nouveau à la surface au niveau d'une deuxième position de bord, prédéterminée pour le dispositif de commande, située en vis-à-vis de la première position de bord sur l'élément (7).

15. Dispositif selon l'une des revendications 11 à 14,
**caractérisé en ce que**
le dispositif de commande est réalisé de telle sorte à ce qu'il puisse commander le premier dispositif laser pour la génération de cette ou ces lignes (2) avec une introduction d'énergie variable du faisceau laser (5) le long des lignes (2).

16. Dispositif selon l'une des revendications 11 à 15,
**caractérisé en ce que**
le dispositif de commande est en liaison avec un dispositif de capteur qui reconnaît des structures présentes à la surface de la pièce à usiner dans la zone des lignes de séparation, et est réalisé de telle sorte qu'en cas de défection de telles structures sur les lignes de séparation, il commande la position de focalisation du faisceau laser (5) lors de la génération de cette ou ces lignes (2) de telle sorte que ces structures soient éliminées avec le faisceau laser (5).
